# EUROPÄISCHE PATENTSCHRIFT

(11) **EP 2 347 301 B1**
(45) Veröffentlichungstag und Bekanntmachung des Hinweises auf die Patenterteilung: **21.08.2019**
(21) Anmeldenummer: 09748759.9
(22) Anmeldetag: 30.10.2009
(51) Int. Cl.: G02F 1/025, H01S 5/50, H01S 5/026

(54) **VORRICHTUNG UND VERFAHREN ZUR SELEKTIVEN TRANSMISSION EINES OPTISCHEN SIGNALS**
DEVICE AND METHOD FOR SELECTIVELY TRANSMITTING AN OPTICAL SIGNAL
DISPOSITIF ET PROCÉDÉ DE TRANSMISSION SÉLECTIVE D'UN SIGNAL OPTIQUE

(30) Priorität: 04.11.2008 DE 102008056096
(43) Veröffentlichungstag der Anmeldung: 27.07.2011
(73) Patentinhaber: Forschungsverbund Berlin E.V., 12489 Berlin (DE)
(72) Erfinder: KLEHR, Andreas, 13156 Berlin (DE); LIERO, Armin, 13187 Berlin (DE)
(74) Vertreter: Gulde & Partner
(86) Internationale Anmeldenummer: PCT/EP2009/064391
(87) Internationale Veröffentlichungsnummer: WO 2010/052176

(56) Entgegenhaltungen:
- EP-A2- 1 065 765
- US-A- 3 724 926
- US-A- 5 546 415
- US-A- 5 793 521
- US-A1- 2003 180 054
- SCHÖLL E ET AL: "GAIN-SWITCHED SEMICONDUCTOR LASER AMPLIFIER AS AN ULTRAFAST DYNAMICAL OPTICAL GATE" APPLIED PHYSICS B. PHOTOPHYSICS AND CHEMISTRY, SPRINGER VERLAG. HEIDELBERG, DE, Bd. B46, Nr. 1, 1. Mai 1988 (1988-05-01), Seiten 69-77, XP000045124

## Beschreibung

Die vorliegende Erfindung betrifft eine Vorrichtung und ein Verfahren zur selektiven Transmission eines optischen Signals, insbesondere betrifft die vorliegende Erfindung eine Vorrichtung und ein Verfahren zur selektiven Transmission einzelner Pulse gepulster Laserstrahlung mit ultrakurzen Pulsbreiten (bis in den Femtosekunden-Bereich, vorzugsweise mit Pulsbreiten zwischen 100 ps - 500 fs) bei extrem variablen Wiederholfrequenzen bis in den GHz-Bereich (vorzugsweise bis zu 300 MHz) für optische Wellenlängen zwischen 200 nm - 10 THz.

Eine Vielzahl von Anwendungen, z.B. bestimmte Bereiche der Lasermaterialbearbeitung, der Photo- und Displaytechnik, von biomedizinischen Screeningtechniken auf der Basis der Fluoreszenzspektroskopie, Laserentfernungsmessung, LIDAR sowie der optischen Analytik erfordern die Bereitstellung von sehr kurzen optischen Impulsen (bis in den Femtosekunden-Bereich) geringer Folgefrequenz (bis zu 100 MHz). Da übliche Kurzpulslasersysteme Impulse mit hoher Folgefrequenz erzeugen, benötigt man schnelle optische Modulatoren (Pulspicker), die in der Lage sind, aus den schnellen Pulszügen einzelne Impulse zu selektieren und zu transmittieren, d.h. eine Frequenzteilung zu erreichen. Dann können diese vereinzelten Impulse getrennt weiterverarbeitet werden. Im Gegensatz zu rein modengekoppelten Lasersystemen, bieten Systeme mit Modulator die Möglichkeit, Pulse nahezu beliebiger Form, Länge und Wiederholrate zu erzeugen.

Zur Pulsselektion ist die Verwendung von Pockelszellen bekannt, die mit nichtlinearen, spannungsabhängigen optischen Kristallen arbeiten. Hierfür werden nachteilhafterweise hohe Spannungen benötigt. Dabei sind die Kapazitäten, die entsprechend umgeladen werden müssen, ebenfalls sehr hoch. Damit ist die erreichbare minimale Pulsweite (damit auch die maximale Eingangs-Pulsfolgefrequenz) und auch die Folgefrequenz des Schalters (und damit die maximale Ausgangs-Pulsfolgefrequenz) stark begrenzt. Es lassen sich Pulsweiten von einigen 10 ns (typisch 30 ns) erreichen. Die Folgefrequenz liegt bei einigen MHz.

Weiterhin ist zur Pulsselektion die Verwendung von akusto-optischen Modulatoren bekannt. Durch Anlegen einer HF-Spannung wird ein stehendes Ultraschallfeld erzeugt. Dieses Feld lenkt dann die optischen Laserimpulse ab. Zum Aufbau eines stehenden Feldes wird Zeit benötigt. Damit lassen sich kurze Impulse von minimal einigen ns erreichen. Die Folgefrequenz ist durch die maximale mittlere Leistung begrenzt, so dass man auch nicht wesentlich über 10 MHz erreicht.

Weiterhin ist zur Pulsselektion die Verwendung von elektro-optischen Modulatoren bekannt. Der einfachste Fall der elektro-optischen Modulatoren besteht aus einem Kristall, z.B. Lithiumniobat, bei dem der Brechungsindex von der Stärke des angelegten elektrischen Feldes abhängt. Damit hängt die Transparenz des Kristalls von der angelegten Feldstärke ab. Elektrooptische Kristalle ändern somit ihre optische Dicke instantan als Funktion der Stärke eines angelegten äußeren elektrischen Feldes. Der Effekt ist abhängig von der Polarisation der einfallenden Strahlung. Für zwei orthogonal zueinander polarisierte Strahlen beträgt der Gangunterschied gerade dann 180°, wenn die sogenannte λ/2-Spannung angelegt wird. Bei entsprechender Kristalljustierung dreht sich für linear polarisiert einfallendes Licht die Polarisationsebene um 90°. Ein Polarisator entfernt das Licht vollständig aus dem Strahlengang. Durch Variation der anliegenden Spannung kann die Intensität des durchgehenden Lichtes dann moduliert werden. Der Modulator kann somit in einfacher Weise als Phasenverzögerungsplatte mit elektrisch einstellbarer Verzögerung verstanden werden. Somit kann durch Variation der Spannung eine optische Pulsselektion erfolgen.

Weiterhin ist zur Pulsselektion die Verwendung eines integriert elektro-optischen Lichtmodulators auf Wellenleiterbasis bekannt. Das Basiselement ist ein fasergekoppelter Mach-Zehnder Amplitudenmodulator auf der Basis des ferroelektrischen Kristallmaterials Lithiumniobat. Die Modulation erfolgt durch elektrooptische Verstimmung des Wellenleiter-Interferometers infolge einer an das Elektrodensystems angelegten elektrischen Spannung.

Bei den beschriebenen Lichtmodulatoren besteht der Nachteil, dass sie relativ groß und justageaufwändig sind, und die Modulationsfrequenz zum Ausschneiden einzelner Impulse begrenzt ist.

US 2005/0206989 A1 offenbart einen multi-bandgap Modulator, der aufgrund separat ansteuerbarer Bereiche unterschiedlicher Bandlücke einen größeren Wellenlängenbereich aufweist bzw. Chirp kompensieren kann.

EP 1 065 765 A2 beschreibt einen Laser mit verbesserter Modulation über einen großen Wellenlängenbereich. Dazu werden Laserdiode und Modulator in einer Struktur, d.h. auf einem gemeinsamen Substrat aufgewachsen, wobei der Modulator mindestens einen ersten und einen zweiten Bereich aufweist, bei denen jeweils durch Anlegen einer Rückwärtsspannung eine Modulation des Lichts der Laserdiode erreicht wird.

US 2003/0180054 A1 offenbart einen optischen Modulator für ultraschnelle Pulse, bei dem Treiberschaltung und Modulator auf einem gemeinsamen Substrat angeordnet sind und der Abstand zwischen der Treiberschaltung und dem optischen Modulator kleiner als ein Zehntel der Wellenlänge der Modulationsfrequenz ist. Durch Verringerung der Induktivitäten der elektrischen Leitungen zwischen Treiberschaltung und optischem Modulator kann die maximale Modulationsfrequenz erhöht werden.

US 3 724 926 A offenbart einen optischen Modulator für ultraschnelle Pulse, welcher zwei Halbleiterdioden umfasst, wobei die eine als Verstärker und die andere als sättigbarer Absorber ausgebildet ist. Im Verstärker erfährt ein zu transmittierendes Eingangssignal eine höhere Verstärkung als ein abzuschwächendes Eingangssignal. Ein erzeugter Intensitätskontrast zwischen beiden Signalen wird anschließend durch den sättigbaren Absorber weiter verstärkt, da dieser Signale mit geringer Intensität deutlich stärker abschwächt als Signale mit hoher Intensität.

Nachteilig an den vorgenannten Modulatoren ist jedoch, dass sich je nach Intensität der Pulse in der Pulspickersektion - d.h. im Modulator - aufgrund von Rekombinationsprozessen Ladungsträger bilden können, die zu einer ungewollten Transparenz der Pulspickersektion führen, obwohl keine Ladungsträger über die Kontakte injiziert werden. Somit verfügt der optische Modulator über eine relativ geringe Durchschlagsfestigkeit.

EP 1 210 754 B1 beschreibt einen EA Modulator mit einem großen Extinktionsverhältnis und einer verbesserten nichtlinearen Extinktionskurve, wobei eine Halbleiterlaserquelle, der EA Modulator sowie ein SOA auf einem Substrate integriert sind. Aus diesem Grund kann diese Vorrichtung nicht zur Modulation extern erzeugter Laserpulse dienen, da diese nicht eingekoppelt werden können. Darüber hinaus lassen sich mit der Vorrichtung lediglich geringe Leistungen modulieren.

Es ist Aufgabe der vorliegenden Erfindung, einen Lichtmodulator und ein Verfahren zur Lichtmodulation anzugeben, mit denen sehr kurze optische Pulse hoher Leistung bis in den Femtosekunden-Bereich mit geringer Folgefrequenz selektiert werden können, wobei die Folgefrequenz in einem Bereich zwischen einigen Hz bis in den GHz-Bereich variabel sein soll. Weiterhin soll die erfindungsgemäße Vorrichtung im Vergleich zu den Vorrichtungen im Stand der Technik möglichst kostengünstig ausgebildet sein und eine hohe Durchschlagsfestigkeit aufweisen.

Diese Aufgaben werden erfindungsgemäß durch einen optischen Modulator und ein Verfahren zur Lichtmodulation mit den in den Patentansprüchen 1 und 11 genannten Merkmalen gelöst. Bevorzugte Ausgestaltungen der Erfindung sind in den Unteransprüchen enthalten.

Ein besonderer Vorteil der erfindungsgemäßen Vorrichtung besteht darin, dass ultrakurze Pulse mit Pulsbreiten kleiner als 10 ps mit einer Folgefrequenz bis in den GHz-Bereich bei gleichzeitig hoher Durchschlagsfestigkeit selektiert werden können.

Dazu weist der erfindungsgemäße optische Modulator eine Einkoppelfacette und einen ersten optischen Wellenleiter auf, der aus elektrisch halbleitenden Materialien ausgebildet, mit der Einkoppelfacette zusammenwirkt und über elektrische Kontakte mit einer ersten Treiberschaltung verbunden ist, wobei der erste Wellenleiter derart ausgebildet ist, dass die optische Transparenz des ersten Wellenleiters durch Injektion von elektrischen Ladungsträgern in den ersten Wellenleiter (um mindestens 10%, bevorzugter 50%) erhöht wird, wobei die erste Treiberschaltung mindestens ein Schaltelement aufweist und ausgebildet ist, über die Kontakte des ersten Wellenleiters für sehr kurze Zeitintervalle und entsprechend einer vorgegebenen Wiederholfrequenz elektrische Ladungsträger in den ersten Wellenleiter zu injizieren. Weiterhin weist der erfindungsgemäße optische Modulator einen zweiten optischen Wellenleiter auf, wobei der erste Wellenleiter zwischen der Einkoppelfacette und dem zweiten Wellenleiter angeordnet ist, und wobei der zweite Wellenleiter aus halbleitenden Materialien ausgebildet ist und über elektrische Kontakte mit einer zweiten Treiberschaltung verbunden ist, wobei die zweite Treiberschaltung mindestens ein Schaltelement aufweist, und der zweite Wellenleiter und die zweite Treiberschaltung ausgebildet sind, das vom ersten Wellenleiter in den zweiten Wellenleiter eingekoppelte optische Signal zu verstärken und/oder dessen Kontrast zu erhöhen, wobei weiterhin eine Auskoppelfacette zur Auskopplung der optischen Strahlung aus dem zweiten Wellenleiter vorgesehen ist.

Erfindungsgemäß können sehr kurze optische Pulse mit Pulsbreiten bis in den Femtosekunden-Bereich mit geringer Folgefrequenz selektiert werden, in dem der Abstand zwischen dem Schaltelement der ersten Treiberschaltung und dem ersten optischen Wellenleiter kleiner als 3 mm beträgt und der Abstand zwischen dem Schaltelement der zweiten Treiberschaltung und dem zweiten optischen Wellenleiter kleiner als 3 mm beträgt und eine hohe Durchschlagsfestigkeit kann erfindungsgemäß dadurch erreicht werden, dass der erste optische Wellenleiter eine erste Absorbersektion, eine Pulspickersektion (entspricht der über die Kontakte transparent bzw. nicht-transparent zu schaltende Wellenleitersektion) sowie eine zweite Absorbersektion aufweist, wobei die erste Treiberschaltung ausgebildet ist, die optische Transparenz der Pulspickersektion durch Injektion von elektrischen Ladungsträgern in Vorwärtsrichtung zu erhöhen (d.h. die Pulspickersektion transparent bzw. nicht-transparent zu schalten), wobei die erste Treiberschaltung so ausgebildet ist, dass während der Injektion von Ladungsträgern in die Pulspickersektion an die erste Absorbersektion und an die zweite Absorbersektion ein elektrisches Feld in Gegenrichtung anzulegen, wodurch ein Durchschlagen des zu modulierenden Signals effizient verhindert werden kann. Insbesondere ist es sonst möglich, dass sich in der Pulspickersektion aufgrund von Rekombinationsprozessen Ladungsträger bilden, die zu einer ungewollten Transparenz der Pulspickersektion führen, obwohl keine Ladungsträger über die Kontakte injiziert werden. Das elektrische Feld in Gegenrichtung saugt die Ladungsträger ab, sodass ohne Injektion von Ladungsträgern in die Pulspickersektion durch elektrischen Strom keine Transparenz der Pulspickersektion erreicht werden kann.

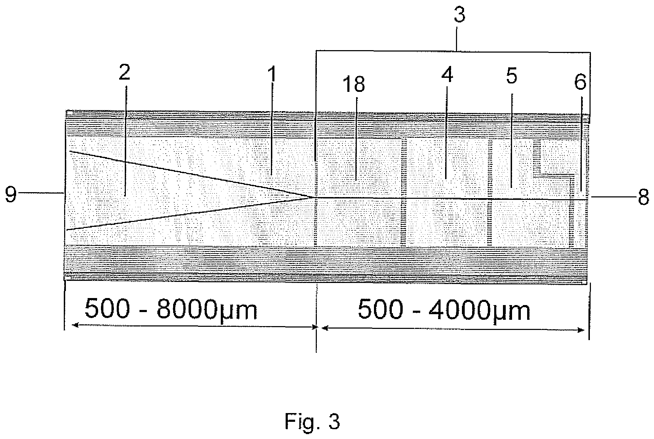

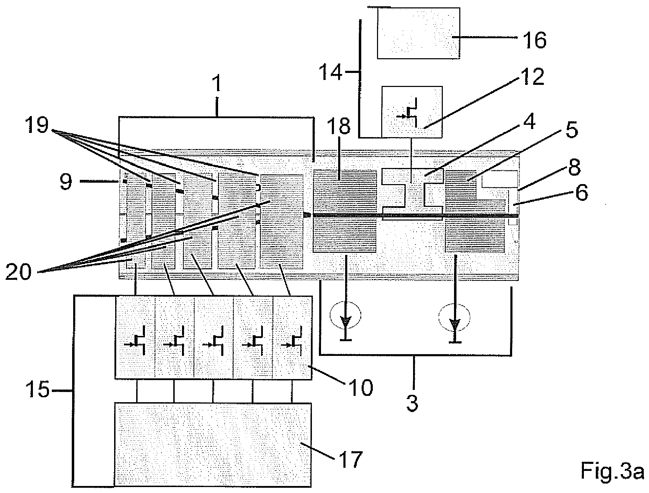

Vorzugsweise sind die erste Absorbersektion zwischen Einkoppelfacette und Pulspickersektion und die zweite Absorbersektion zwischen Pulspickersektion und Auskoppelfacette angeordnet. Weiterhin ist es bevorzugt, dass eine Sektion zur Einkoppeljustage (vorzugsweise ein HF Eingangselement) zwischen der Einkoppelfacette und der ersten Absorbersektion angeordnet ist. Diese Eingangssektion wird als Fotodiode geschaltet. Um hochfrequent detektieren zu können, soll die aktive Fläche möglichst klein sein. Daher ist die Länge der Sektion zur Einkoppeljustage entlang der optischen Achse im zentralen Bereich (unter dem ridge waveguide) vorzugsweise kleiner 40 µm. Dieses wird durch die in Fig. 3 eingezeichnete Kontaktstruktur erreicht, die eine seitliche Kontaktierung vorsieht.

Es handelt sich bei der erfindungsgemäßen Vorrichtung mit anderen Worten um einen optischen Modulator zur Modulation externer erzeugter und über die Einkoppelfacette eingekoppelte gepulste Laserstrahlung, der als Wellenleiter ausgebildet ist, wobei die optische Transparenz der einzelnen Sektionen über elektrische Kontakte (Injektion von ladungsträgern) gesteuert werden kann.

Vorzugsweise beträgt der Abstand zwischen dem Schaltelement der ersten Treiberschaltung und dem ersten optischen Wellenleiter weniger als 2 mm (noch bevorzugter weniger als 1 mm). Vorzugsweise beträgt der Abstand zwischen dem Schaltelement der zweiten Treiberschaltung und dem zweiten optischen Wellenleiter weniger als 2 mm (noch bevorzugter weniger als 1 mm). Gemäß der vorliegenden Erfindung wird als Abstand zwischen dem elektrischen Schaltelement und dem Wellenleiter als Abstand zwischen dem Ausgang (z.B. Drain) des elektrischen Schaltelements und dem Mittelpunkt des vertikal zur Lichtausbreitungsrichtung angeordneten Bereiches des Wellenleiters verstanden, durch den (über die Lichteintrittsfacette) die zu modulierende Strahlung in den Wellenleiter eingekoppelt wird.

Vorzugsweise weisen die Lichteintrittsfacette und die Lichtaustrittsfacette eine optische Transmission für die zu modulierende optische Strahlung (die zwischen 200 nm - 10 THz liegen kann) größer als 80%, noch bevorzugter größer als 90% auf.

Vorzugsweise besitzen der erste Wellenleiter im transparent geschalteten Zustand (d.h. während der Injektion von Ladungsträgern) eine optische Transmission für die zu modulierende optische Strahlung (die zwischen 200 nm - 10 THz liegen kann) größer als 50%, noch bevorzugter größer als 90% und im nicht-transparent geschalteten Zustand eine optische Transmission kleiner 50%, bevorzugter kleiner als 30%, noch bevorzugter kleiner als 1%.

Vorzugsweise ist die erste Treiberschaltung ausgebildet, in den ersten Wellenleiter elektrische Ladungsträger für ein jeweils vorgegebenes Zeitintervall und mit einer vorgegebenen Wiederholfrequenz zu injizieren, wobei das Zeitintervall vorzugsweise zwischen 10 ps und 1 ns und die Wiederholfrequenz vorzugsweise zwischen 1 kHz und 1 GHz beträgt.

Grundsätzlich ist die Anordnung der elektrischen Schaltelemente der Treiberschaltung und des optischen Schalters (Wellenleiter) direkt nebeneinander mit einem erhöhten Aufwand aufgrund der Notwendigkeit des besonders genauen Positionierens während des Montageprozesses verbunden, so dass es grundsätzlich nicht naheliegt, diese Komponenten mit einem Abstand kleiner als 3 mm anzuordnen. Es wurde jedoch gefunden, dass für das Transparent-Schalten Wiederholfrequenzen bis in den GHz-Bereich bei extrem kurzen Pulsen bis in den Pikosekunden-Bereich durch geringe Induktivitäten erreicht werden können.

Vorzugsweise sind der erste optische Wellenleiter und der zweite optische Wellenleiter auf demselben Substrat integriert. Besonders bevorzugt sind der erste optische Wellenleiter und der zweite optische Wellenleiter durch ein monolithisches Mehrsektions-Halbleiterbauelement ausgebildet, d.h. der erste und der zweite Wellenleiter können durch Epitaxie und Layout gemeinsam ausgebildet werden, sind jedoch räumlich voneinander getrennt.

Vorzugsweise weist die erste Treiberschaltung einen ersten Ansteuergenerator und die zweite Treiberschaltung einen zweiten Ansteuergenerator auf, wobei Mittel zur Einstellung der Frequenz des ersten Ansteuergenerators und/oder Mittel zur Einstellung der Frequenz des zweiten Ansteuergenerators vorgesehen sind. Hierdurch ist es möglich, die Wiederholfrequenz des Pulspickers zu variieren. Vorzugsweise sind der erste Ansteuergenerator und der zweite Ansteuergenerator miteinander synchronisiert, wobei die Frequenz des ersten Ansteuergenerators ein ganzzahliges Vielfaches der Frequenz des zweiten Ansteuergenerators ist.

Vorzugsweise weist der erste optischen Wellenleiter und der zweite optische Wellenleiter einen Abstand zwischen 10 µm und 500 µm auf. Vorzugsweise weist die erste Absorbersektion und die Pulspickersektion bzw. die Pulspickersektion und die zweite Absorbersektion einen Abstand zwischen 10 µm und 500 µm auf.

Vorzugsweise ist der erste optische Wellenleiter als ridge waveguide ausgebildet.

Hierbei wird die laterale Wellenführung durch einen Brechungsindexsprung in der Epitaxieebene erreicht, der durch selektives Ätzen eines Steges (ridges) in den Wellenleiter erzeugt wird. Vorzugsweise liegen die Stegbreiten im Bereich von 1,5 - 10 µm. Durch diese Steggeometrie wird nicht nur die optische Welle eingeengt, sondern auch der Stromfluss auf den Stegbereich begrenzt. Hierdurch erreicht man geringere Laserschwellen und eine bessere Wellenführung. Für die Modulation (transparent, nicht-transparent Schalten) benötigt man mit dieser Geometrie nur geringere Modulationsströme. Stegwellenleiterlaser zeigen ein sehr gutes, nahezu gaußförmiges Strahlprofil mit (Beugungsmaßzahl M² ∼ 1).

Vorzugsweise ist der erste optische Wellenleiter als Breitstreifenlaser ausgebildet.

Bei Breitstreifenlasern ist die optische Wellenführung schlechter und der benötigte Modulationsstrom höher. Typischerweise liegen die Breiten für den elektrischen Kontakt im Bereich von >10 - 400 µm. Vorteil dieser Laser ist, dass höhere optische Leistungen geschaltet bzw. erzeugt werden können. Nachteil ist das schlechtere Strahlprofil (M² < 10) der emittierten Strahlung.

Vorzugsweise ist der zweite Wellenleiter als Taperlaser ausgebildet ist. Durch die Benutzung eines Trapezteils als 2. Wellenleiter wird erreicht, dass die mit gutem Strahlprofil aus dem ridge waveguide Wellenleiter in den Trapezwellenleiter eingekoppelte Strahlung verstärkt werden kann, ohne das sich das Strahlprofil signifikant ändert. Man erhält verstärkte Strahlung mit gutem Strahlprofil (M² < 2 - 3).

Die erfindungsgemäße Vorrichtung wird vorzugsweise zur Modulation optischer Laserpulse größer 20 mW verwendet. Die Ladungsträger werden zur Modulation der optischen Laserpulse vorzugsweise intervallweise in die Pulspickersektion vorzugsweise mit einer Stromstärke von 100 mA bis 1 A, noch bevorzugter mit einer Stromstärke größer als 1 A (in einem Zeitintervall kleiner als 5 ns) injiziert.

Die Erfindung wird nachfolgend anhand von in den Figuren dargestellten Ausführungsbeispielen näher erläutert. Es zeigen:
- Fig. 1: die erfindungsgemäße Vorrichtung zur selektiven Transmission eines optischen Signals in einer schematischen, perspektivischen Darstellung,
- Fig. 2: eine schematische Darstellung der Vorrichtung gemäß Fig. 1 in Aufsicht,
- Fig. 3: eine schematische Darstellung mit detaillierter Darstellung des Kontakt Layouts des ersten optischen Wellenleiters zur selektiven Transmission bei gleichzeitig erhöhter Durchschlagsfestigkeit eines optischen Signals in Aufsicht,
- Fig. 3a: eine schematische Darstellung mit detaillierter Darstellung des Kontakt Layouts des ersten optischen Wellenleiters zur selektiven Transmission bei gleichzeitig erhöhter Durchschlagsfestigkeit eines optischen Signals sowie detaillierter Darstellung des Kontakt Layouts des zweiten optischen Wellenleiters mit einer Vielzahl von separaten Kontakten und absorbierenden Bereichen oberhalb der Trapezsektion in Aufsicht,
- Fig. 4: ein Ausführungsbeispiel einer Treiberschaltung der erfindungsgemäßen Vorrichtung, und
- Fig. 5: eine Darstellung der zu modulierenden Impulsfolge aus einem modengekoppelten Diodenlaser mit einer Frequenz von 4GHz (obere Abbildung) sowie die transmittierte Impulsfolge (ausselektierte Impulse) nach Durchlauf durch die erfindungsgemäße Vorrichtung (untere Abbildung).

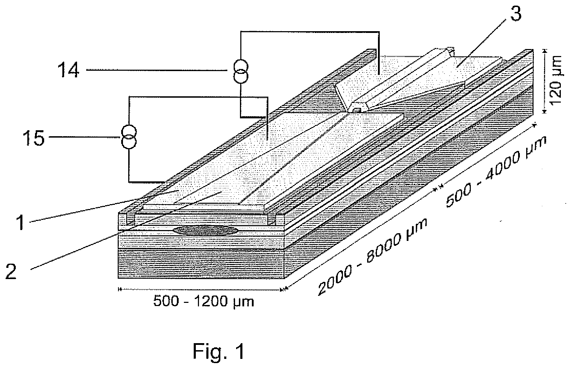

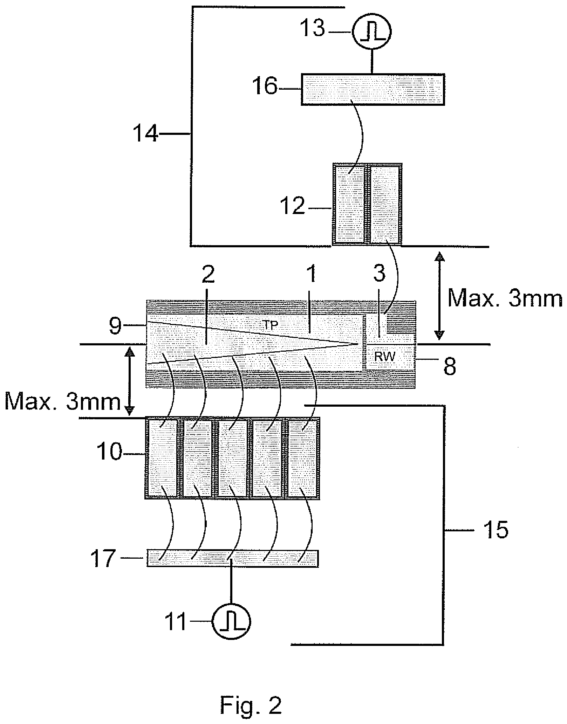

Die Fig. 1 und 2 zeigen ein Ausführungsbeispiel einer erfindungsgemäßen Vorrichtung zur selektiven Transmission eines optischen Signals in schematischer Darstellung.

Die Anordnung wird mit monolithischen 2- oder Mehrsektions-Halbleiterbauelementen (Fig. 3) aufgebaut. Dabei ist mindestens eine erste Sektion durch einen Wellenleiter 3 (1. Wellenleiter, z.B. ridge waveguide) ausgebildet, die für eine hohe zeitliche Auflösung bis hin in den Pikosekunden-Bereich sorgt, während mindestens eine zweite Sektion 1 mit einem verstärkenden Bereich 2 (2. Wellenleiter) die optische Leistung im monolithischen Bauelement nach Durchgang durch die erste Sektion erhöht und den Kontrast im langsameren Zeitbereich (größer 1 ns) verbessert. Mit anderen Worten bildet die erste Sektion 3 einen ultraschnellen optischen Schalter aus, der bis in den Pikosekunden-Bereich zwischen transparent und nicht-transparent geschaltet werden kann, während die zweite Sektion die Pulse, die im Falle einer transparent geschalteten ersten Sektion die zweite Sektion erreichen, in einem langsameren Zeitbereich (größer 1 ns) verstärkt bzw. den Kontrast verbessert. Mit anderen Worten wird aus einer ultraschnellen Pulsfolge ein einzelner Puls durch transparent Schalten der ersten Sektion zur zweiten Sektion transmittiert, wobei eine Vielzahl nachfolgender Pulse durch nicht-transparent Schalten der ersten Sektion absorbiert bzw. gedämpft werden. Die Frequenz bzw. Folge, mit der einzelne der ultraschnellen Pulse transmittiert werden, kann erfindungsgemäß eine Frequenz bis in den GHz-Bereich aufweisen. In der zweiten Sektion werden die transmittierten, ultraschnellen Pulse in einem langsameren Zeitbereich (größer 1 ns) verstärkt bzw. deren Kontrast verbessert.

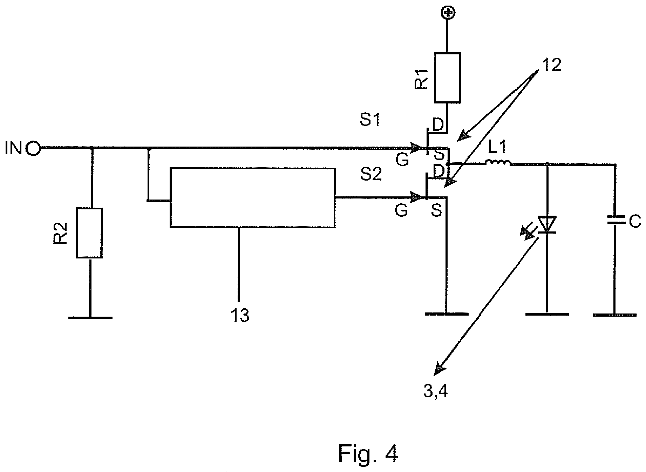

Entscheidend für eine hohe Geschwindigkeit des transparent Schaltens der ersten Sektion 3 ist die schnelle Umladung der Kapazitäten des Wellenleiters 3. Damit die Zeitkonstanten klein bleiben, werden Wellenleiter 3 und Treiberschaltung 14, als Einheit aufgebaut. Geringe Induktivitäten L1 und damit kurze Schaltzeiten erreicht man durch extrem kleine Aufbauten mit kleinen Kontaktflächen und sehr kurzen Zuleitungen (Fig. 4).

Der Schalter S1 sorgt für schnelles Anschalten des Wellenleiterstroms für den ersten Wellenleiter 3, Die positive Flanke des Eingangsimpulses schließt den Schalter S1 und der Strom fließt über R1, S1 und L1 über den Wellenleiter 3 und parasitären Kondensator C. Nach einer einstellbaren Zeitkonstante schließt zusätzlich S2 und der Strom fließt jetzt über den niederohmigeren S2 und entlädt dabei auch den parasitären Kondensator C. Damit kann dann nur über ein kurzes Zeitintervall, das im Wesentlichen durch die Zeitkonstante des Ansteuergenerators 13 vorgegeben ist, Transparenz des Wellenleiters 3 eintreten. Das Schalten des Wellenleiters 3 wird somit nur von einer Flanke getriggert und ist von der Länge des Eingangsimpulses unabhängig. Kurze Zeit nach dem Impuls ist die Schaltung wieder einsatzbereit. Dadurch können hohe Folgefrequenzen realisiert werden. Dieses Delay kann aber auch von externen Komponenten separat erzeugt werden, um eine größere Variabilität zu erreichen.

Durch Einspeisung von Offset-Spannungen lässt sich die Ansteuerung der selbstleitenden FET's (S1, S2) verbessern. Das Sperrverhalten der Laserdioden (Wellenleiter) lässt sich durch Einfügen von negativen Offsetspannungen positiv beeinflussen.

Eine hohe Durchschlagsfestigkeit kann erfindungsgemäß dadurch erreicht werden, dass der erste optische Wellenleiter eine erste Absorbersektion 5, eine Pulspickersektion 4, bei der ein Kontakt mit möglichst geringer Fläche zur Verringerung der Induktivitäten realisiert wird, (entspricht der über die Kontakte transparent bzw. nicht-transparent zu schaltende Wellenleitersektion) sowie eine zweite Absorbersektion 18 aufweist, wobei die erste Treiberschaltung 14 ausgebildet ist, die optische Transparenz der Pulspickersektion 4 durch Injektion von elektrischen Ladungsträgern in Vorwärtsrichtung zu erhöhen (d.h. die Pulspickersektion transparent bzw. nicht-transparent zu schalten), wobei die erste Treiberschaltung 14 weiterhin ausgebildet ist, während der Injektion von Ladungsträgern in die Pulspickersektion 4 an die erste Absorbersektion 5 und an die zweite Absorbersektion 18 ein elektrisches Feld in Gegenrichtung anzulegen, wodurch ein Durchschlagen des zu modulierenden Signals effizient verhindert werden kann (Fig. 3 und 3a). Insbesondere ist es sonst möglich, dass sich in der Pulspickersektion 4 aufgrund von Rekombinationsprozessen Ladungsträger bilden, die zu einer ungewollten Transparenz der Pulspickersektion 4 führen, obwohl keine Ladungsträger über die Kontakte injiziert werden. Das an die Regionen 5 und 18 angelegte elektrische Feld in Gegenrichtung saugt die Ladungsträger ab, so dass ohne Injektion von Ladungsträgern in die Pulspickersektion 4 durch elektrischen Strom keine Transparenz der Pulspickersektion 4 erreicht werden kann.

In einer weiteren bevorzugten Ausführungsvariante sollen die elektrischen Kontaktflächen 20 oberhalb des Verstärkers (zweiter Wellenleiter 1) sektioniert werden und zwischen den Kontaktflächen absorbierende Bereiche 19 bleiben (Fig. 3a), so dass getrennt ansteuerbare Verstärkerstufen realisiert werden können. Das Layout ist so realisiert, dass jede Kontaktfläche oberhalb des verstärkenden Bereiches 2 V eine gleiche Fläche (gleiche Pumpfläche) hat. Die Zahl der Kontaktflächen ist an die Zahl der integrierten Endstufentransistoren 10 angepasst. Die Treiberschaltung 15 für den zweiten Wellenleiter ist derart ausgebildet, dass eine parallele Ansteuerung der einzelnen Verstärkerstufen oder alternativ eine Verstärkerkaskade realisiert werden kann, bei der die Verstärkerstufen kaskadenartig, also hintereinander angesteuert werden. Die Trapezsektion 2 (Verstärker) kann von 1.....n Stufen, vorzugsweise zwischen 3 und 10 Stufen eingeteilt werden.

Die zweite Sektion (Wellenleiter 1, 2, z.B. Trapezsektion) erhöht die maximale Ausgangsleistung und verstärkt den Kontrast für Eingangsimpulse, die weiter vom zu selektierenden Impuls entfernt sind. Der Aufbau der Ansteuerschaltung 15 erfolgt analog Fig. 4. Wegen der notwendig höheren Ströme hat die Treiberstufe 15 eine höhere Stromergiebigkeit.

Insbesondere bilden der elektrische Treiber (Halbleitertransistoren S1, S2) und das optische Element (Wellenleiter 3) eine integrierte Funktionseinheit. Wird als Ausgangssignal ein cw-Lasersignal eingespeist, kann durch die erfindungsgemäße Vorrichtung auch gepulste Laserstrahlung aus cw-Laserstrahlung erzeugt werden.

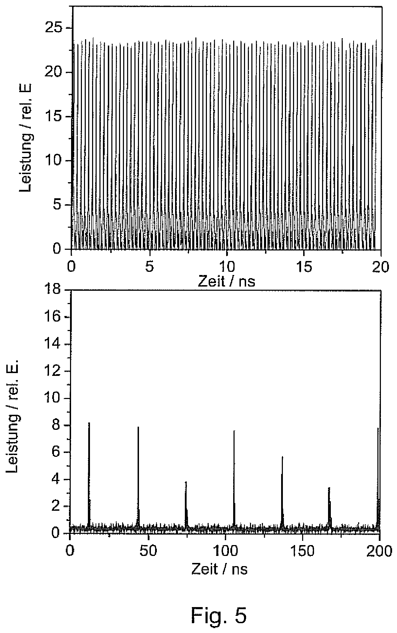

Fig. 5 zeigt eine Messung einer Impulsfolge aus einem (nicht gezeigten) modengekoppelten Diodenlaser mit einer Folgefrequenz von 4GHz (obere Darstellung) sowie die nach Durchgang durch den erfindungsgemäßen Pulspicker erhaltene Impulsfolge (ausselektierte Impulse des Eingangssignals - untere Darstellung).

### Bezugszeichenliste

- 1: Trapezsektion des (zweiten) optischen Wellenleiters/ optischen Verstärkers
- 2: verstärkender Bereich des (zweiten) optischen Wellenleiters/ optischen Verstärkers
- 3: (erste) optische Wellenleitersektion/ optischer Schalter/ Pulspicker
- 4: Pulspickersektion
- 5: erste Absorbersektion
- 6: Sektion zur Einkoppeljustage
- 8: Einkoppelfacette
- 9: Auskoppelfacette
- 10: Ansteuertransistor für den zweiten Wellenleiter
- 11: Ansteuergenerator für den zweiten Wellenleiter
- 12: Ansteuertransistor für den ersten Wellenleiter
- 13: Ansteuergenerator für den ersten Wellenleiter
- 14: Treiberschaltung für den ersten Wellenleiter
- 15: Treiberschaltung für den zweiten Wellenleiter
- 16: Vorverstärker für den ersten Wellenleiter
- 17: Vorverstärker für den zweiten Wellenleiter
- 18: zweite Absorbersektion
- 19: absorbierende Bereiche zur Unterdrückung der ASE
- 20: elektrische Kontaktfläche bzw. Flächen des Verstärkers

- RW: Ridge Waveguide - Wellenleiter
- TP: Trapezbereich
- R1, R2: Widerstand
- S1, S2: Transistor
- L1: Bondinduktivität
- C: parasitäre Kapazität der Laserdiode

## Patentansprüche

1. Vorrichtung zur selektiven Transmission eines optischen Signals mit variabler, einstellbarer Frequenz, aufweisend:
- eine Einkoppelfacette (8) zur Einkopplung eines optischen Signals,
- einen als ersten optischen Wellenleiter (3) ausgebildeten elektro-optischen Modulator zur Modulation eines eingekoppelten optischen Signals, der mit der Einkoppelfacette (8) zusammenwirkt und über elektrische Kontakte mit einer ersten Treiberschaltung (14) verbunden ist, wobei der erste Wellenleiter (3) aus einem Material ausgebildet ist, dessen optische Transmission durch Injektion von elektrischen Ladungsträgern erhöht wird,
- wobei die erste Treiberschaltung (14) mindestens ein elektrisches Schaltelement (12) zur Injektion (3) elektrischer Ladungsträger für ein jeweils vorgegebenes Zeitintervall und mit einer vorgegebenen Wiederholfrequenz in den ersten Wellenleiter (3) aufweist,
- einen als zweiten optischen Wellenleiter (1, 2)) ausgebildeten optischen Verstärker zur Verstärkung und/oder Kontrasterhöhung des vom ersten Wellenleiter (3) in den zweiten Wellenleiter (1, 2) eingekoppelten optischen Signals, wobei der erste Wellenleiter (3) zwischen der Einkoppelfacette (8) und dem zweiten Wellenleiter (1, 2) angeordnet ist, und wobei der zweite optische Wellenleiter (1, 2) über elektrische Kontakte mit einer zweiten Treiberschaltung (15) verbunden ist, wobei die zweite Treiberschaltung (15) mindestens ein Schaltelement (10) aufweist, und
- eine Auskoppelfacette (9) zur Auskopplung der optischen Strahlung aus dem zweiten Wellenleiter (1, 2),
- wobei der Abstand zwischen dem Schaltelement (12) der ersten Treiberschaltung (14) und dem ersten optischen Wellenleiter (3) weniger als 3 mm beträgt,
**dadurch gekennzeichnet, dass** der erste optische Wellenleiter (3) eine erste Absorbersektion (5), eine Pulspickersektion (4) sowie eine zweite Absorbersektion (18) aufweist, wobei die erste Treiberschaltung (14) ausgebildet ist, die optische Transparenz der Pulspickersektion (4) durch Injektion von elektrischen Ladungsträgern zu erhöhen, und wobei die erste Treiberschaltung (14) weiterhin ausgebildet ist, während der Injektion von Ladungsträgern in die Pulspickersektion (4) an die erste Absorbersektion (5) und an die zweite Absorbersektion (18) ein elektrisches Feld in Gegenrichtung anzulegen.

2. Vorrichtung nach Anspruch 1,
**dadurch gekennzeichnet, dass**
der zweite optische Wellenleiter (1, 2) als Trapezlaser mit einer Trapezsektion (2) ausgebildet ist, wobei der zweite optische Wellenleiter (2) eine Vielzahl von separaten Verstärkerstufen mit dazwischen liegenden absorbierenden Bereichen aufweist, die jeweils mit einem separat geschalteten Ansteuertransistor verbunden sind.

3. Vorrichtung nach Anspruch 2,
**dadurch gekennzeichnet, dass**
die Vielzahl von Verstärkerstufen die gleiche Kontaktfläche zur Injektion von Ladungsträgern aufweist.

4. Vorrichtung nach einem der vorhergehenden Ansprüche,
**dadurch gekennzeichnet, dass**
der Abstand zwischen dem Schaltelement (12) der ersten Treiberschaltung (14) und dem ersten optischen Wellenleiter (3) weniger als 1 mm beträgt und der Abstand zwischen dem Schaltelement (10) der zweiten Treiberschaltung (15) und dem zweiten optischen Wellenleiter (1, 2) weniger als 1 mm beträgt.

5. Vorrichtung nach einem der vorhergehenden Ansprüche,
**dadurch gekennzeichnet, dass**
der erste optische Wellenleiter (3) und der zweite optische Wellenleiter (1, 2) auf demselben Substrat integriert sind und der erste optischen Wellenleiter (3) und der zweite optische Wellenleiter (1, 2) aus elektrisch halbleitenden Materialien ausgebildet sind.

6. Vorrichtung nach einem der vorhergehenden Ansprüche,
**dadurch gekennzeichnet, dass**
eine Sektion (6) zur Einkoppeljustage vorgesehen, wobei die Sektion (6) zur Einkoppeljustage zwischen der Einkoppelfacette (8) und dem ersten optischen Wellenleiter (3) angeordnet ist und die Sektion (6) zur Einkoppeljustage auf demselben Substrat wie der erste optische Wellenleiter (3) und der zweite optische Wellenleiter (1, 2) integriert ist.

7. Vorrichtung nach einem der vorhergehenden Ansprüche,
**dadurch gekennzeichnet, dass**
der erste optischen Wellenleiter (3) und der zweite optische Wellenleiter (1, 2) einen Abstand zwischen 10 µm und 500 µm aufweisen.

8. Vorrichtung nach einem der vorhergehenden Ansprüche,
**dadurch gekennzeichnet, dass**
die erste Treiberschaltung (14) zur intervallweisen Injektion elektrischer Ladungsträger in den ersten Wellenleiter (3) derart ausgebildet ist, dass der erste Wellenleiter (3) während der Injektion von Ladungsträgern eine optische Transmission größer einem ersten Grenzwert aufweist, und der erste Wellenleiter (3) während eines Zeitintervalls, in dem Ladungsträger nicht injiziert werden, eine optische Transmission kleiner einem zweiten Grenzwert aufweist, wobei der erste Grenzwert größer als der zweite Grenzwert ist.

9. Vorrichtung nach einem der vorhergehenden Ansprüche,
**dadurch gekennzeichnet, dass**
der erste optische Wellenleiter (3) als ridge waveguide, der erste optische Wellenleiter (3) als Breitstreifenlaser und/oder der zweite Wellenleiter (1, 2) als Trapezlaser ausgebildet ist.

10. Vorrichtung nach einem der vorhergehenden Ansprüche,
**dadurch gekennzeichnet, dass**
das Schaltelement (12) der ersten Treiberschaltung (14) und/oder das Schaltelement (10) der zweiten Treiberschaltung (15) als Transistor ausgebildet ist.

11. Verfahren zur Erzeugung gepulster Laserstrahlung, mit folgenden Verfahrensschritten:
- Einkoppeln eines optischen Signals in eine Vorrichtung nach einem der Patentansprüche 1-10,
- intervallweise Injektion elektrischer Ladungsträger in den ersten Wellenleiter (3) zur selektiven Transmission des eingekoppelten optischen Signals,
- wobei das selektierte optische Signal im zweiten optischen Wellenleiter (1, 2) verstärkt wird und/oder der Kontrast des selektierten optischen Signals im zweiten optischen Wellenleiter (1, 2) erhöht wird.

12. Verfahren nach Patentanspruch 11,
**dadurch gekennzeichnet, dass**
die optische Transparenz der Pulspickersektion (4) durch Injektion von elektrischen Ladungsträgern in Vorwärtsrichtung in die Pulspickersektion (4) erhöht wird, wobei gleichzeitig an die erste Absorbersektion (5) und an die zweite Absorbersektion (18) ein elektrisches Feld in Gegenrichtung zur Erhöhung der Durchschlagsfestigkeit angelegt wird.

13. Verfahren nach einem der Patentansprüche 11 und 12,
**dadurch gekennzeichnet, dass**
als einzukoppelndes optisches Signal gepulste Laserstrahlung mit einer Pulsbreite kleiner als 10 ns verwendet wird.

14. Verfahren nach Patentanspruch 13,
**dadurch gekennzeichnet, dass**
als einzukoppelndes optisches Signal gepulste Laserstrahlung mit einer Pulsbreite kleiner als 1 ns verwendet wird.

15. Verfahren nach Patentanspruch 14,
**dadurch gekennzeichnet, dass**
als einzukoppelndes optisches Signal gepulste Laserstrahlung mit einer Pulsbreite kleiner als 1 ps verwendet wird.

## Claims

1. A device for selective transmission of an optical signal with variable adjustable frequency, comprising:
- an input coupling facet (8) for coupling an optical signal in,
- an electro-optical modulator configured as a first optical waveguide (3) for modulating an optical signal coupled in, the electro-optical modulator cooperating with the input coupling facet (8) and being connected via electrical contacts with a first drive circuit (14), wherein the first waveguide (3) is configured from a material having an optical transmission that is increased through injection of electrical charge carriers,
- wherein the first drive circuit (14) has at least one electrical switching element (12) for injection (3) of electrical charge carriers into the first waveguide (3) for a corresponding predetermined time interval and with a predetermined repetition frequency,
- an optical amplifier configured as a second optical waveguide (1, 2) for amplification and/or contrast enhancement of the optical signal coupled from the first waveguide (3) into the second waveguide (1, 2), wherein the first waveguide (3) is arranged between the input coupling facet (8) and the second waveguide (1, 2), and wherein the second optical waveguide (1, 2) is connected via electrical contacts with a second drive circuit (15), wherein the second drive circuit (15) has at least one switching element (10), and
- an output coupling facet (9) for coupling the optical radiation out of the second waveguide (1, 2),
- wherein the spacing between the switching element (12) of the first drive circuit (14) and the first optical waveguide (3) is less than 3 mm,
**characterised in that**
the first optical waveguide (3) has a first absorber section (5), a pulse picker section (4) and a second absorber section (18), wherein the first drive circuit (14) is configured to increase the optical transparency of the pulse picker section (4) through injection of electrical charge carriers, and wherein the first drive circuit (14) is furthermore configured to apply an electric field in the opposite direction to the first absorber section (5) and the second absorber section (18) while the charge carriers are injected into the pulse picker section (4).

2. The device according to Claim 1,
**characterised in that**
the second optical waveguide (1, 2) is configured as a trapezoidal laser with a trapezoidal section (2), wherein the second optical waveguide (2) has a plurality of separate amplifier stages with absorbing regions arranged in between, with each of the absorbing regions being connected to a separately switched drive transistor.

3. The device according to Claim 2,
**characterised in that**
the plurality of amplifier stages has identical contact surfaces for injection of charge carriers.

4. The device according to any one of the preceding claims,
**characterised in that**
the spacing between the switching element (12) of the first drive circuit (14) and the first optical waveguide (3) is less than 1 mm, and the spacing between the switching element (10) of the second drive circuit (15) and the second optical waveguide (1, 2) is less than 1 mm.

5. The device according to any one of the preceding claims,
**characterised in that**
the first optical waveguide (3) and the second optical waveguide (1, 2) are integrated on the same substrate and the first optical waveguide (3) and the second optical waveguide (1, 2) are configured from electrically semiconducting materials.

6. The device according to any one of the preceding claims,
**characterised in that**
a section (6) is provided for input coupling adjustment, wherein the section (6) for input coupling adjustment is arranged between the input coupling facet (8) and the first optical waveguide (3) and the section (6) for input coupling adjustment is integrated on the same substrate as the first optical waveguide (3) and the second optical waveguide (1, 2).

7. The device according to any one of the preceding claims,
**characterised in that**
the first optical waveguide (3) and the second optical waveguide (1, 2) have a spacing between 10 µm and 500 µm.

8. The device according to any one of the preceding claims,
**characterised in that**
the first drive circuit (14) for intermittent injection of electrical charge carriers into the first waveguide (3) is configured such that the first waveguide (3) has an optical transmission greater than a first limit value during the injection of charge carriers, and the first waveguide (3) has an optical transparency which is smaller than a second limit value during a time interval when the charge carriers are not injected, wherein the first limit value is greater than the second limit value.

9. The device according to any one of the preceding claims,
**characterised in that**
the first optical waveguide (3) is configured as a ridge waveguide, the first optical waveguide (3) is configured as a broad area laser and/or the second waveguide (1, 2) is configured as a trapezoidal laser.

10. The device according to any one of the preceding claims,
**characterised in that**
the switching element (12) of the first drive circuit (14) and/or the switching element (10) of the second drive circuit (15) are configured as transistors.

11. A method for producing pulsed laser radiation comprising the steps of:
- coupling an optical signal into a device according to any one of Claims 1-10,
- intermittent injection of electrical charge carriers into the first waveguide (3) for selective transmission of the coupled optical signal,
- wherein the selected optical signal is amplified in the second optical waveguide (1, 2) and/or the contrast of the selected optical signal in the second optical waveguide (1, 2) is increased.

12. The method according to Claim 11,
**characterised in that**
the optical transparency of the pulse picker section (4) is increased through injection of electrical charge carriers into the pulse picker section (4) in the forward direction, while an electric field is simultaneously applied to the first absorber section (5) and to the second absorber section (18) in the opposite direction in order to increase the dielectric strength.

13. The method according to any one of Claims 11 and 12,
**characterised in that**
pulsed laser radiation with a pulse width of less than 10 ns is used as the optical signal to be coupled in.

14. The method according to Claim 13,
**characterised in that**
pulsed laser radiation with a pulse width of less than 1 ns is used as the optical signal to be coupled in.

15. The method according to Claim 14,
**characterised in that**
pulsed laser radiation with a pulse width of less than 1 ps is used as the optical signal to be coupled in.

## Revendications

1. Procédé pour la transmission sélective d'un signal optique avec fréquence réglable variable, présentant :
- une facette d'injection (8) pour l'injection d'un signal optique,
- un modulateur électro-optique formé comme un premier guide d'ondes optique (3) pour la modulation d'un signal optique injecté, lequel interagit avec la facette d'injection (8) et est connecté à un premier circuit d'attaque (14), le premier guide d'ondes (3) étant formé dans un matériau dont la transmission optique est augmentée par injection de porteurs de charge électriques,
- le premier circuit d'attaque (14) présentant au moins un élément de commutation électrique (12) pour l'injection (3), dans le premier guide d'ondes (3), de porteurs de charge électriques pour un intervalle de temps respectivement spécifié et avec une fréquence de répétition spécifiée,
- un amplificateur optique formé comme un deuxième guide d'ondes optique (1, 2) pour l'amplification et/ou l'augmentation de contraste du signal optique injecté par le premier guide d'ondes (3) dans le deuxième guide d'ondes (1, 2), le premier guide d'ondes (3) étant disposé entre la facette d'injection (8) et le deuxième guide d'ondes (1, 2), et le deuxième guide d'ondes optique (1, 2) étant connecté à un deuxième circuit d'attaque (15) par des contacts électriques, le deuxième circuit d'attaque (15) présentant au moins un élément de commutation (10), et
- une facette de sortie (9) pour la sortie du rayonnement optique hors du deuxième guide d'ondes (1, 2),
- la distance entre l'élément de commutation (12) du premier circuit d'attaque (14) et le premier guide d'ondes optique (3) étant inférieure à 3 mm,
**caractérisé en ce que**
le premier guide d'ondes optique (3) présente une première section d'absorption (5), une section de sélection d'impulsion (4) ainsi qu'une deuxième section d'absorption (18), le premier circuit d'attaque (14) étant formé pour augmenter la transparence optique de la section de sélection d'impulsion (4) par injection de porteurs de charge électriques, et le premier circuit d'attaque (14) étant en outre formé pour appliquer un champ électrique en sens inverse à la première section d'absorption (5) et à la deuxième section d'absorption (18), pendant l'injection de porteurs de charge dans la section de sélection d'impulsion (4).

2. Dispositif selon la revendication 1,
**caractérisé en ce que**
le deuxième guide d'ondes optique (1, 2) est formé comme laser trapézoïdal avec une section trapézoïdale (2), le deuxième guide d'ondes optique (2) présentant une pluralité d'étages d'amplificateur séparés avec des zones absorbantes disposées de façon intermédiaire, lesquelles sont respectivement connectées avec un transistor d'excitation connecté séparément.

3. Dispositif selon la revendication 2,
**caractérisé en ce que**
la pluralité d'étages d'amplificateur présentent la même surface de contact pour l'injection de porteurs de charge.

4. Dispositif selon l'une quelconque des revendications précédentes,
**caractérisé en ce que**
la distance entre l'élément de commutation (12) du premier circuit d'attaque (14) et le premier guide d'ondes optique (3) est inférieure à 1 mm, et **en ce que** la distance entre l'élément de commutation (10) du deuxième circuit d'attaque (15) et le deuxième guide d'ondes optique (1, 2) est inférieure à 1 mm.

5. Dispositif selon l'une quelconque des revendications précédentes,
**caractérisé en ce que**
le premier guide d'ondes optique (3) et le deuxième guide d'ondes optique (1, 2) sont intégrés au même substrat, et **en ce que** le premier guide d'ondes optique (3) et le deuxième guide d'ondes optique (1, 2) sont formés dans des matériaux électriquement semi-conducteurs.

6. Dispositif selon l'une quelconque des revendications précédentes,
**caractérisé en ce qu'**
une section (6) est prévue pour l'alignement d'injection, la section (6) pour l'alignement d'injection étant disposée entre la facette d'injection (8) et le premier guide d'ondes optique (3), et la section (6) pour l'alignement d'injection étant intégrée sur le même substrat que le premier guide d'ondes optique (3) et que le deuxième guide d'ondes optique (1, 2).

7. Dispositif selon l'une quelconque des revendications précédentes,
**caractérisé en ce que**
le premier guide d'ondes optique (3) et le deuxième guide d'ondes optique (1, 2) présentent une distance entre 10 µm et 500 µm.

8. Dispositif selon l'une quelconque des revendications précédentes,
**caractérisé en ce que**
le premier circuit d'attaque (14) est formé pour l'injection par intervalles de porteurs de charge électriques dans le premier guide d'ondes (3) de telle sorte que le premier guide d'ondes (3) présente une transmission optique supérieure à une première valeur seuil pendant l'injection de porteurs de charge, et que le premier guide d'ondes (3) présente une transmission optique inférieure à une deuxième valeur seuil pendant un intervalle de temps au cours duquel des porteurs de charge ne sont pas injectés, la première valeur seuil étant supérieure à la deuxième valeur seuil.

9. Dispositif selon l'une quelconque des revendications précédentes,
**caractérisé en ce que**
le premier guide d'ondes optique (3) est formé comme guide d'ondes à moulures, le premier guide d'ondes optique (3) est formé comme laser à ruban large et/ou le deuxième guide d'ondes (1, 2) est formé comme laser trapézoïdal.

10. Dispositif selon l'une quelconque des revendications précédentes,
**caractérisé en ce que**
l'élément de commutation (12) du premier circuit d'attaque (14) et/ou l'élément de commutation (10) du deuxième circuit d'attaque (15) sont formés comme des transistors.

11. Procédé pour la génération de rayonnement laser pulsé, avec les étapes de procédé suivantes :
- injection d'un signal optique dans un dispositif selon l'une des revendications 1-10,
- injection par intervalles de porteurs de charge électriques dans le premier guide d'ondes (3) pour la transmission sélective du signal optique injecté,
- le signal optique sélectionné étant amplifié dans le deuxième guide d'ondes optique (1, 2) et/ou le contraste du signal optique sélectionné étant augmenté dans le deuxième guide d'ondes optique (1, 2).

12. Procédé selon la revendication 11,
**caractérisé en ce que**
la transparence optique de la section de sélection d'impulsion (4) est augmentée par injection de porteurs de charge électriques vers l'avant dans la section de sélection d'impulsion (4), un champ électrique étant appliqué en même temps en sens inverse à la première section d'absorption (5) et à la deuxième section d'absorption (18) pour l'augmentation de la résistance disruptive.

13. Procédé selon l'une des revendications 11 et 12,
**caractérisé en ce que**
du rayonnement laser pulsé avec une largeur d'impulsion inférieure à 10 ns est employé comme signal optique devant être injecté.

14. Procédé selon la revendication 13,
**caractérisé en ce que**
du rayonnement laser pulsé avec une largeur d'impulsion inférieure à 1 ns est employé comme signal optique devant être injecté.

15. Procédé selon la revendication 14,
**caractérisé en ce que**
du rayonnement laser pulsé avec une largeur d'impulsion inférieure à 1 ps est employé comme signal optique devant être injecté.
